# EUROPEAN PATENT SPECIFICATION

(11) **EP 3 126 859 B1**
(45) Date of publication and mention of the grant of the patent: **06.06.2018**
(21) Application number: 15720456.1
(22) Date of filing: 01.04.2015
(51) Int. Cl.: G01R 31/26, H02S 50/10

(54) **TESTING DEVICE**
TESTVORRICHTUNG
DISPOSITIF DE TEST

(30) Priority: 04.04.2014 EP 14163602
(43) Date of publication of application: 08.02.2017
(73) Proprietor: Pasan Sa, 2000 Neuchâtel (CH)
(72) Inventor: ROCHAT, Julien, 1400 Yverdon-les-Bains (CH); HILLER, Jonas, 3007 Bern (CH); REBEAUD, Nicolas, 1189 Saubraz (CH); AMBÜHL, Alessandro, 2000 Neuchâtel (CH)
(74) Representative: Patentbüro Paul Rosenich AG
(86) International application number: PCT/IB2015/052407
(87) International publication number: WO 2015/151049

(56) References cited:
- WO-A1-2014/013350
- DE-A1-102010 019 955
- DE-A1-102012 017 564

## Description

The invention refers to a testing device for testing a photovoltaic device, particularly a wafer being processed to form a solar cell, a solar cell element, a solar cell and/or a string of solar cells, having electrical contacts on at least one of its flat surfaces, the testing device comprising,
- a support having a receiving surface for receiving the photovoltaic device,
- at least one measurement device,
- at least one electrical interface having exposed electrical contacts for abutting against at least one of the electrical contacts of the photovoltaic device, in order to establish a temporary electrical connection,
- forcing means for forcing the electrical interface and the photovoltaic device against each other when the photovoltaic device is received by the support,
wherein the electrical interface is connected to the measurement device.

Here "receiving the photovoltaic device" may be understood in that the photovoltaic device is directly or indirectly held or supported by the support. In the latter case, an additional member (e.g. an electrical interface) may be interposed. The contacts of the photovoltaic device may be any portion of its surface that is usually used for collecting electrical power. This may be a metalized portion or for example be a TCO layer. Ideally, these contacts represent or simulate the contact later used in the module.

The invention also refers to a testing method according to the preamble of claim 15. The inventive testing device is especially suited for measuring the power output of photovoltaic devices. Moreover, it allows to beneficially contact a photovoltaic device and measure and/or control nay of the current and voltage. Such devices may be used in sun-simulators also called flashers, that are commonly known in the industry.

Some of current and future solar cells do not show any bus-bars anymore. Their front- and back-contacts are becoming very various (different patterns) and cell metallization with only fingers on the top and the backside may be found. Sometimes fingers are interrupted and some designs (back-contacting cells) even don't have any metallization on the topside anymore. These back-contacting cells have both, the positive and the negative electrodes on the backside of the cell, which requires quite complex metallization structures on the cell's backsides.

Offering reliable and flexible contacting solutions for all these various kinds of cell metallization designs becomes very challenging for manufacturer of testing devices for testing photovoltaic devices. Even more, as each cell manufacturer wants to optimize its metallization design and thus has to test several different (prototype) metallization designs, each requiring an individually adapted contacting solution.

Additionally, cells should be tested the way they are contacted in the solar cell module. The cell manufacturer should be able to simulate the different interconnection methods in solar cells, e.g. Day4/smart wire technology (lots of wires, thin wires, exact number may be different for different module manufacturers); 2,3,4 or 5 bus bars, etc.

There is the need to find a flexible contacting structure in order to adapt to these rapidly changing metallization designs/requirements with the following requirements:
- Contact points/areas at various positions (for contacting the positive and negative zones of the pv-device with voltage and current pins), particularly for four-point measurements;
- Positive and negative electrodes are wildly mixed over the back (and/or front) side of the pv-device;
- A contacting mechanism is preferred which has very little or no (light) shading on the top side of the cell.
- For laboratory measurements, there is the need to heat and cool the pv-device at different temperatures and keep it at the chosen temperatures (for measuring the cell's temperature behavior). A good thermal contact with the pv-device (thermal energy flow should not be hindered) is preferred.
- Future cells do not show full covering backside metallization anymore and are transparent to light (in order to allow reflection at the module's back-sheet or to collect ambient light from the back of the cells); for measuring the impact of this transparent backside of solar cells, it may be required to offer the back-contacting structure at different colors (fully reflective, diffuse or specular reflection, different colors, fully absorbing, etc.).

These requirements cannot be achieved by current contacting solutions: e.g. spring probes, electrically conductive wires, pressing an electrical wire grid on the cell, flexible bearing blades.

Spring probes (e.g. known from CN102023235 A, HR20120081 T1, JP2010177379 A) consist of needle pins, guided in a tube and preloaded by springs. For contacting the bus bar of the solar cell, an array of several spring probes are aligned over the bus bar and are fixed on a fixation bar. These designs require many delicate assembly steps. The needle pins are very delicate and are easily damaged. The cross section of the contact areas is also very small as compared to that of ribbons connected to the bus bar. Also the array of spring probes has to be repeated for each bus bar. In addition for bus bar less cells, the contact of the probes does not resemble the contact later in the cell, introducing an undefined error. When contacting fingers, it is notoriously hard to hit the fingers with the probes.

In case of bent wires approach, bent metallic wires are used. They are fixed outside the cell area in order to minimize the cast shadows on the solar cell. Precise alignment of the wire tips on the bus bar requires delicate assembly. Also the cross section of the contact is very small (and very different from the interconnecting in the solar module) and the number of contact point is limited by the complicated design.

Supported wires used as electrical contacting means (as e.g. known form CN201945665 U, DE102011081004 A1, US2007068567 A1) are fixedly connected along their entire length to a longitudinal support extending over the solar cell to be contacted. The longitudinal support carrying the wire (which is at least partially bare, with no insulation) forces the wire against the solar cell. The support has to be stiff and mechanically stable to exert this force. This leads to undesirable large and heavy supports casting much shade onto the solar cell.

US2010045264A1 discloses a probe for temporarily electrically contacting a solar cell for testing purposes having a plurality of contact elements with angled configuration and whose lower terminals (tips) to be laid on the electrode terminals of a solar cell for producing the electrical contact.

US2012306524A1 does not relate to the testing of photovoltaic devices. This document discloses an apparatus for contacting a plurality of contact location of a semiconductor device. Probe members in form of wires are held by a support. A PCB has a plurality of apertures for micro-coaxial segments. The PCB is used as a support for holding/feeding through the wires or probes. The probe members are fixed on the support by means of an adhesive substance.

DE102012017564A1 discloses an apparatus for temporarily contacting a solar cell for testing purposes. A plurality of electrically conductive wires extends on a glass plate. The glass plate is sucked by means of under-pressure towards the solar cell and the electrically conductive wires come into contact with the electrical contact zones of the solar cell. It is assumed that due to the pressing mechanism a spatially uniform and reliable contacting quality cannot be achieved. Further, the force exerted by the metal wires may damage the solar cell.

DE102010019955A1 relates to different technical field and discloses a testing device for testing electrical components. A conductor board is used for establishing the electrical contact with a measurement device.

WO2014013350A1 discloses a testing device for testing photovoltaic devices. As electrical contacting means at least one flexible and electrically conductive wire is used. As already mentioned with respect to DE102012017564 A1 metal wires may have a negative mechanical impact on the pv-device.

Spring probes (e.g. known from CN102023235A, HR20120081T1, JP2010177379A) consist of needle pins, guided in a tube and preloaded by springs. For contacting the bus bar of the solar cell, an array of several spring probes are aligned over the bus bar and are fixed on a fixation bar. These designs require many delicate assembly steps. The needle pins are very delicate and are easily damaged. The cross section of the contact areas is also very small as compared to that of ribbons connected to the bus bar. Also the array of spring probes has to be repeated for each bus bar. In addition for bus bar less cells, the contact of the probes does not resemble the contact later in the cell, introducing an undefined error. When contacting fingers, it is notoriously hard to hit the fingers with the probes. In case of bent wires approach, bent metallic wires are used. They are fixed outside the cell area in order to minimize the cast shadows on the solar cell. Precise alignment of the wire tips on the bus bar requires delicate assembly. Also the cross section of the contact is very small (and very different from the interconnecting in the solar module) and the number of contact point is limited by the complicated design.

Supported wires used as electrical contacting means (as e.g. known from CN201945665U,

DE102011081004A1, US2007068567A1) are fixedly connected along their entire length to a longitudinal support extending over the solar cell to be contacted. The longitudinal support carrying the wire (which is at least partially bare, with no insulation) forces the wire against the solar cell. The support has to be stiff and mechanically stable to exert this force. This leads to undesirable large and heavy supports casting much shade onto the solar cell.

US2010045264A1 discloses a probe for temporarily electrically contacting a solar cell for testing purposes having a plurality of contact elements with angled configuration and whose lower terminals (tips) to be laid on the electrode terminals of a solar cell for producing the electrical contact.

All these solutions are an assembly of several unique components, which require a complex assembly and are inflexible to match with new metallization designs.

Main problems of these solutions are: complex assembly, low flexibility for adapting to new metallization designs, difficult to adapt to back-contacting cells with two (or more) electrical polarities on one side of the pv-device, expensive manufacturing costs.

The object of the invention is to overcome these problems and to provide a solution to reliably electrically contact a flat photovoltaic device, particularly (back-contacting) cells, wafers or any intermediate stage thereof, for testing purposes. The solution should be capable of matching with complex contact structures on the surface of the pv-device. The solution should have a simple and cost effective construction. In a preferred embodiment it should be possible to test different metallization type structures with minimal adaption effort. A place-saving design is preferred.

This object is achieved with a testing device as mentioned at the beginning wherein the electrical interface comprises a printed circuit surface formed by printed conducting structures on electrically insulating material, and wherein the testing device comprises at least one flexible member of electrically insulating material, the flexible member cooperating with or forming the forcing means to force the electrical interface and the photovoltaic device against each other.

The combination of a printed circuit surface for electrically contacting the pv-device and at least one flexible member of electrically insulating material for forcing the photovoltaic device against the printed circuit surface yields several advantages: Among them are a uniform and protective forcing and at the same time a (spatially) uniform and reliable contacting of the pv-device. Printed circuit surfaces may be produced very precisely providing a uniform contacting all over the pv-device. This uniform contacting is further improved by the at least one flexible member of electrically insulating material. The flexibility provides a uniform force distribution on the pv-device. Negative mechanical impacts on the electrical-contacting side of the pv-device are also efficiently prevented by the use of the printed circuit surface. The printed circuit surface and its contacting structures may be formed in a gentle and/or flat manner.

At the same time the electrically insulating material of the flexible member prevents (local) electrical short cuts or leakages; i.e. the flexible member(s) do not influence the testing performance of a pv-device. The flexible member(s) of electrically insulating material guarantee(s) in co-operation with the printed circuit surface same (i.e. uniform) conditions all over the spatial extension of the pv-device.

It is therefore preferred that on one (first) side of the pv-device only the electrically insulating material of the flexible member abuts against the pv-device and that the other (second) side of the pv-device is contacted by the printed circuit surface. The first side of the pv-device stays electrically un-coupled from the testing device or any of its parts (also during the measurement procedure). Here, the testing device is adapted to receive the photovoltaic device between the printed circuit surface and the flexible member(s). The electrically insulating material of the flexible member faces towards the printed circuit surface.

In a preferred embodiment, a top part of the testing device comprising the flexible member(s) may be fixed (i.e. stationary), and a bottom part comprising the support (with receiving surface) is movable (vertically) up towards the flexible member(s). A drive moving the bottom part is then part of the forcing means cooperating with the flexible member(s) to sandwich the pv-device between receiving surface and flexible member(s).

The testing device may be adapted such that - in the measurement position - on the first side of the photovoltaic device only the electrically insulating material of the flexible member abuts against the photovoltaic device and that the second side of the photovoltaic device is electrically contacted by the printed circuit surface, wherein the first side of the photovoltaic device is - in the measurement position - electrically un-coupled from the testing device or from any of its parts.

In a most preferred embodiment the printed circuit surface is - at least in the measurement position (i.e. with received pv-device and pressed against the printed circuit surface) - convex shaped towards the at least one flexible member. By pressing the photovoltaic device against the printed circuit surface by means of the flexible member(s), the photovoltaic device will be bent according to the contour of the receiving surface or printed circuit surface. This allows a more uniform contacting of all contacts on the flat surface of the photovoltaic device.

The flexible member may be directly coupled to the forcing means (drive, press, actuator, etc.). The flexible member may also cooperate with the forcing means as a counterpart (flexible counterplot or flexible stop), i.e. the at least one flexible member is held stationary and the forcing means move the pv-device against the flexible member.

Thus, the flexible member is used for directly or indirectly transferring the force of the forcing means to the electrical interface and/or to the photovoltaic device.

Preferably, the flexible member is adapted to directly touch or to snuggle against the photovoltaic device (in the measurement position). The electrically insulating material of the flexible member touches - in the measurement position - the pv-device. It is not necessary that the whole flexible member is made of electrically insulating material. At least the abutting surface, which in the measurement position abuts against the pv-device is made of electrically insulating material, preferably soft material.

Preferably, the flexible member has longitudinal extension and wherein the flexible member and/or a longitudinal reinforcing element connected to the flexible member is tensioned in the direction of the longitudinal extension of the flexible member, wherein preferably the tension in the flexible member and/or in the reinforcing element is higher than 10 N, preferably higher than 30 N.

Preferably, the flexible member has a straight run when not being in contact with the photovoltaic device.

Preferably, the testing device comprises tensioning means acting on the flexible member in a direction of the longitudinal extension of the flexible member.

The tension guarantees a defined shape of the flexible member and thus uniform and reliable pressing (forcing) conditions.

Preferably, the flexible member has longitudinal (wire-like) shape. It is preferred that the flexible wire has a abutting section which in the abutting position of the flexible member abuts against the photovoltaic device. The flexible member extends freely at least in its abutting section, which in the abutting position of the flexible member abuts against the photovoltaic device. In the release position, the abutting section of the flexible member is a freely extending section; in the contacting (measurement) position the freely extending abutting section abuts against the photovoltaic device.

Preferably, the flexible member(s) extend freely at least in its abutting section between a first and second holding member (i.e. there is no additional holding member or support member connected to or supporting the abutting section of the flexible member). This allows the flexible member to easily adapt its run to the contour of the surface of the photovoltaic device and/or the support surface. With other words: In the release position the abutting section of the flexible member freely hangs between first and second holding member(s); in the contacting (or measurement) position the freely extending abutting section abuts against the photovoltaic device.

Preferably, the flexible member is a wire. In an embodiment the wire may be an insulated wire, wherein the electrically insulating material of the flexible member is the insulation of the wire.

Preferably, the flexible member is a flexible nylon wire.

Preferably, the flexible wire comprises reinforcing fibers.

Preferably, the flexible member comprises (or is formed by) a jacket of electrically insulating material, the jacket surrounding at least one strand, wherein preferably the tensile strength of the at least one strand is higher than the tensile strength of the jacket. The at least one strand is a (longitudinal) reinforcing element. Here, while the flexible member stays flexible, the E-module or the tensile strength thereof is increased so that it can withstand larger tensile stresses. Here, e.g. a cable or insulated wire may be used as flexible member. Preferably, the jacket has an E-module smaller than 20GPa. Preferably, the strand has an E-Module greater than 20GPa. Preferably, the E-moduli of the jacket and the strand differ from each other by a factor of at least 2, more preferred of at least 5, most preferred of at least 10.

Preferably, a plurality of flexible members may be used, e.g. parallel extending wires forming a wire web.

The use of flexible members, particularly wires, of electrically insulating material allows a fixation of the pv-device relative to the electrical interface in a very protective way, since metallic wires usually have a negative impact on the pv-device and may cause scrapes and/or even breaking of the pv-device. Furthermore, members of electrically insulating material do not influence the testing performance of a pv-device (e.g. by short-cuts). An important advantage is that such members may be formed by transparent or semi-transparent materials, which is advantageous if light sources and/or light detectors are directed to a surface of the pv-device. The conditions may be thus simulated very realistic.

Flexible wires may be also shiny causing no real shading because light will reflect onto the pv-device. Here, it is preferred that the flexible wire(s) ideally have a triangular shape.

Preferably, the at least one flexible member is a wire, a grid, a mesh, a web or a flexible foil or layer, wherein preferably the flexible member is transparent.

Preferably, the flexible member continuously extends above the receiving surface over at least one edge of the receiving surface, preferably over two opposing edges. This allows to arrange the forcing means (drive and/or holding structure for the wires) laterally of the receiving surface.

The electrically insulating material on which the printed conducting structures are formed may e.g. be a plastic, fiber and/or resin substrate or film. It is however possible that the electrically insulating material is a thin layer or coating of e.g. electrically non-conducting metal-oxide, such as an aluminum-oxide layer formed on an aluminum core. The electrically insulating material may be also structured (e.g. a two dimensional pattern) and/or formed on a metallic core. This metallic core may be also used for conducting current and/or transmitting voltage to the exposed electrical contacts.

The contact surfaces of the exposed electrical contacts (which are adapted to touch the contacts of the photovoltaic device) are in electrically conducting communication with the printed conducting structures of the printed circuit surface. This allows e.g. voltage and/or current measurements or applications by directly using the printed conducting structures of the printed circuit surface.

The term printed circuit surface is understood in the present application as comprising "printed circuit layer" and/or "printed circuit structure" as forming a printed circuit layer or structure in the surface region of the electrical interface.

In a preferred embodiment at least one exposed electrical contact, preferably some or all electrical contacts, is/are each connected to the electrically insulating material in an immovable manner, such that the exposed electrical contact (or each exposed electrical contact) as a whole is immovable with respect to the electrically insulating material. In this context "as a whole" means that any portion of the exposed electrical contact is immobile with respect to the electrically insulating material or substrate.

The contact surface - as a whole - of the exposed electrical contacts (which will touch the contacts of the photovoltaic device in the measurement setup position) are immovable with respect to the electrically insulating material or substrate. This means that any portion of the exposed electrical contact is immobile with respect to the electrically insulating material or substrate, i.e. there is no movable portion of an exposed electrical contact. This allows - in combination with a printed circuit surface - to provide a reliable and durable electrical interface, since the electrical contacts as such do not constitute movable parts which are usually prone to wearing, as is the case in prior art spring probe techniques. At the same time a printed conducting structure allows a contacting patterns of each design.

Preferably, the exposed electrical contacts are capable to transmit the force, which results from pressing the photovoltaic device and the electrical interface together, to a conducting path of the printed circuit surface or to an electrically insulating material of the printed circuit surface. The corresponding force path thereby extends from the contact surface (disposed to touch an electrical contact of the pv-device) of the exposed electrical contact towards that portion of the exposed electrical contact that is in touch with the conducting path or with the electrically insulating material of the printed circuit surface. The force path extends essentially perpendicular to the printed circuit surface, i.e. between opposing end surfaces of an exposed electrical contact. The force path thus runs essentially parallel to the current and/or voltage path within the exposed electrical contact. This allows a compact and place saving construction and reliable solution without the risk of losing electrical connection during the pressing force acting upon the exposed contacts.

In a preferred embodiment at least one, preferably some, of the exposed electrical contacts is/are formed by the printed conducting structures of the printed circuit surface, preferably by gold-plated contacts. In this case the printed circuit structures are directly used as contacting zones. The exposed electrical contacts may be elevated above the electrically insulating material/substrate by means printing or growing technologies of locally depositing material (e.g. anodization, (electro-)plating, plasma depositing or spraying, CVD, etc).

In this embodiment the electrical interface comprises a printed circuit surface with the exposed electrical contacts formed by printed conducting structures, preferably gold-plated contacts, on a surface of electrically insulating material.

In an alternate embodiment at least one, preferably some, of the exposed electrical contacts is/are each formed by an electrically conducting member that is connected to a printed conducting structure of the printed circuit surface, preferably by means of solder or electrically conducting adhesive. The electrically conducting member may be e.g. a pad, i.e. a small plate-like member, soldered to a printed conducting structure of the printed conducting surface.

Preferably, the contact surface of the exposed electrical contacts (the contact surface comes into touch with the pv-device) is elevated with respect to the electrically insulating material (e.g. substrate), preferably by a distance not exceeding 2mm, preferably not exceeding 1mm.

The invention relates to the testing of flat or plate-like photovoltaic devices and guarantees a reliable electrical contact between a flat photovoltaic device, particularly a (bus-barless) solar cell or a string of solar cells, with minimal mechanical stress and good repeatable contact quality. The testing device allows a place-saving construction, since the printed circuit surface may be applied on a thin substrate. Due to the fact that the printed circuit technology is an advanced technology an electrical interface may be produced in a cost-effective way. The inventive idea allows to precisely adapt the pattern of printed electrically conducting structures forming the printed circuit surface to the contact pattern on the flat surface of the photovoltaic device to be tested.

In the measurement position (i.e. with received pv-device) the printed circuit surface abuts with the exposed electrical contacts parallel against the flat surface of the pv-device, allowing an essentially planar contact of all exposed electrical contacts of the printed circuit surface with contacts of the pv-device. The exposed electrical contacts and/or the conducting structures/paths of the printed circuit surface/layer are preferably formed by flat and/or layer-like conducting structures.

Preferably, exposed electrical contacts of the printed circuit surface are interconnected with each other and/or with connectors leading to the measurement device by means of conducting paths running within the printed circuit surface (or within a PCB) and being covered by a layer of electrically insulating material. Thus, in contrast to the wire contacting according to prior art (causing an electrical contact along the entire length of the wire) the inventive solution allows to selectively contact the pv-device by an individual pattern of exposed electrical contacts. The printed conducting paths covered by an layer of insulated material does not contribute to the direct contact area. I.e. the interconnections run within the printed circuit surface but are covered by an insulator.

Preferably, at least one exposed electrical contact is connected to a conducting path (covered by electrically insulating material) by means of a resistor, that is preferably made in thick film technology. The resistor may be covered by electrically insulating material as well.

Preferably, the exposed electrical contacts of the printed circuit surface form a two-dimensional pattern, wherein preferably the area of each exposed electrical contact has a width not exceeding 1cm and a length not exceeding 1cm or a diameter not exceeding 1cm. This allows to selectively contact different areas of the pv-device.

Preferably, the exposed electrical contacts are made by locally growing the contacting areas, preferably by copper. Growing is performed by deposition of electrically conducting material, e.g. by anodization or in thin or thick film technology. In the course of growing the contact surface of the exposed electrical contacts becomes elevated with respect to the electrically insulating material of the printed circuit layer.

Locally growing the contacting zones (i.e. exposed electrical contacts) yields a good 3D profile, which exceeds the insulation layer and helps to penetrate the cell's metallization

The idea is to locally grow the exposed electrical contacts, preferably by anodization. In a preferred subsequent step an additional gold plating may be applied to the grown electrical contacts. In a most preferred embodiment copper is covered by gold.

Preferably, exposed electrical contacts are interconnected by a conducting path of the printed circuit surface, the conducting path being at least locally connected to, preferably covered by, an electrically insulating material of the printed circuit surface, wherein preferably a first group of exposed electrical contacts has a larger, contact area, preferably at least twice as large, than a second group of exposed electrical contacts.

Preferably, exposed electrical contacts of the first group and exposed electrical contacts of the second group are alternately arranged one after another along a line, respectively.

This is just an exemplary embodiment for back contacting cells with a continuous line to be connected. For many future contacting designs, the contacting regions on the cell may become very small and it will be possible to provide only one current contact and one voltage contact for each contacting region of the cell. One example would be interrupted fingers, for which it could be possible to put one current contact and one voltage contact for each finger segment. It would be also possible that future cells, e.g. IBC (Interdigitated-Back-Contact) cells will have no metallization contacts at all.

Preferably, the testing device comprises at least two printed circuit surfaces with different pattern of exposed electrical contacts. The printed circuit surfaces are exchangeable in order to account for the testing of different pv-devices.

A printed circuit surface may be any surface with electrically conducting structures, particularly paths, spots and/or pattern, on an electrically insulating or dielectric substrate. In the scope of the present invention the term "printed" is particularly understood as any application or deposition (plasma deposition, sputtering, plating, int-jet printing, etc.) of any kind of electrically conductive material (particularly metal, e.g. copper, gold, etc., or a combination thereof, layer, as alloy or any combination thereof); as well as selectively removing (chemical treatment as e.g. etching, lasing, etc.) electrically conductive material for forming the conducting structures. Accordingly, printed conducting structures are electrically conducting structures on a printed circuit surface.

According to different technologies electrical circuits can be printed on any substrate or material, particularly plastic, resin or rubber material. The material may be synthetic or natural, reinforced or flexible. Masks may be used for the deposition or ablation process and/or excess material may be removed later (e.g. by laser application). It is also possible that the electrically conductive material is applied onto a substrate, where it only adheres/holds on a pre-treated or pre-printed seed layer. Different methods may be used comprising screen and/or ink jet printers.

Industrial technics of creating electrical circuits may comprise: Standard PCB (FR4, MCPCB, FlexPCB); combination of flexible and rigid parts; PCB with carbon contacts (similarly to keyboard application); Gold plated contact zones with black (insulated) mask; Thick Film PCBs; deposition of passive electrical elements by using thick film technics (e.g. screen printing); LTCC (Low Temperature Co-Fired Ceramic); FlexPCB; 2D or 3D printing of conductive paste; Screen-printing technologies or etching of photosensitive layers (photolithography); growth (anodization, electrochemical plating, electroplating, electro-deposition) of zones; making conductive zones by light (laser) activation, chemical activation, printing; mechanical shaping (milling, cutting, stamping) of a conductive substrate; chemical removing of material (etching, etc.) and combinations of the above mentioned technologies.

The electrical contacts may be small, localized contacts on a printed circuit of electrical conducting paths (e.g. mimicking the interconnecting in the cell or behind metallization in order not to produce shading). The electrical contacts or contacting regions of the printed circuit surface may be (slightly) higher than the printed conducting paths (e.g. by electrochemical plating or screen printing).

The printed circuit surface comprises first contacts of a first polarity (minus) and second contacts of a second polarity (plus). The printed circuit surface thus comprises contacts related to the minus pole of the pv-device and contacts related to the plus pole of the pv-device.

The electrically insulating material may be preferably a layer on an electrically conductive material, such as a layer of anodized aluminum on an aluminum plate.

Preferably, the printed circuit surface comprises a plurality of electrical contacts distributed over the whole printed circuit surface.

Any of the following elements may have elastic properties (e.g. spring elements on a PCB, flexible parts of the PCB with an elevated part for touching pv-device) in order to adapt to mechanical imperfections and in order to assure a good electrical contact for all contacting regions: the electrical contacting points, the printed circuit surface/layer, the substrate supporting the printed circuit surface, an intermediate layer between the printed circuit surface/layer and a forcing means, the forcing means itself.

The electrical contacting regions on the printed circuit surface may be plated by other materials (Ni, Au, Ag) in order to improve the electrical contact and to reduce resistivity and to prevent oxidation or other aging.

The electrical contacts of the printed circuit surface may be thermally treated in order to reduce its wear off. Other printed conducting paths may be masked by an electrically insulated layer. This electrically insulated layer may be of any color. This electrically insulated layer may be optimized for assuring a good thermal exchange between the pv-device and a support/base of the testing device. The electrically insulated layer may have a certain elasticity in order to adapt to height irregularities in the pv-device or the circuit layers. This electrically insulated layer can be applied by screen-printing, putting a precut layer, etc.

A photovoltaic device (sometimes also: pv-device) may be or comprise e.g. a wafer, a solar cell (sub)element, a solar cell, a string or array of solar cells, a solar cell module or subassembly thereof or any combination thereof. Multiple interconnected cells may be contacted as a whole or only a subset thereof may be contacted. The term solar cell and solar module may refer to any technology including crystalline and thin film technologies and combinations thereof.

An electrical contact area of the photovoltaic device may contain e.g. a bus bar, a finger, an area of the photovoltaic device such as part of its active surface, a connector for interconnecting ribbons or any combination thereof. The electrical contact areas are arranged on the top and/or back surface of the photovoltaic device. A photovoltaic device usually comprises at least two different kinds of contact areas, one of them being related to the plus and one of them being related to the minus pole.

The inventive method allows both, performing electroluminescence and measuring of IN-curves. The inventive solution could also be used to measure the resistivity between contact points, e.g. 'busbar-to-busbar measurements', in order to extract the sheet resistivity of the solar cell. But also other measurements can be done, where the pv-device should be electrically contacted at one or both sides, with one or multiple polarities and for current and/or voltage connections. The term "measurement device" as used in this description and claims may therefore be understood as measurement detector (e.g. voltmeter and/or ampere meter) and/or as measurement power supply (e.g. voltage source and/or current source). The testing device according to the invention may thus be used to apply and/or pick up current or voltage or both form the photovoltaic device (particularly solar cell).

Preferably, (temperature) sensors are integrated on the printed circuit surface or in the immediate vicinity thereof. The sensors are preferably connected to the measurement device.

Preferably, the testing device comprises a forcing means for forcing the printed circuit surface and the photovoltaic device against each other when the photovoltaic device is received by the support. The electrical contact may be established in a more reliable and repeatable manner, if the electrical interface and the photovoltaic device are pressed with their flat surfaces against each other. The forcing means may comprise a drive (e.g. a motor or a cylinder), an actuator and/or a pump. The pump may be a vacuum pump or a pressure pump. The forcing means my also comprise at least one transmission element for (directly or indirectly) transmitting the force produced by the drive, actuator or pump to the photovoltaic device or to the electrical interface. The transmission element of the forcing means may be e.g. non-conductive (flexible) wires.

Possible forcing means (or pressing devices) may comprise:
- wire grid on top of the cell, which presses the solar cell on a bowed support;
- the top wires may be insulated;
- additionally to or instead of wires bands, cords or transparent foils may be used;
- additionally to or instead of wires a transparent foil may be used;
- a transparent flexible foil, pressing onto the cell, which is placed on a flat or bowed support;
- in the measurement position the printed circuit surface may be arranged between the pv-device and a (lower) support portion;
- devices, based on pressure volumes (flexible container, filled with gas or liquid or gel).

Preferably, the forcing means comprises suction means, wherein preferably the printed circuit surface has a plurality of suction openings (e.g. holes or gaps) chargeable with underpressure. The photovoltaic device is attracted towards the electrical interface by means of underpressure and thus held in a fixed position. In this embodiment no mechanical means are required for pressing the photovoltaic device against the electrical interface. Mechanical stresses and the risk of destroying the photovoltaic device may be effectively reduced.

Preferably, the support has a convex shape defining a convex receiving surface. By pressing the photovoltaic device against the convex receiving surface, the photovoltaic device will be bent according to the contour of the receiving surface. This allows a more uniform contacting of all contacts on the flat surface of the photovoltaic device.

Preferably, the convex run of the receiving surface is defined such that the height difference between the highest point (central region of the receiving surface) and the lowest point (peripheral region) of the convex run of the receiving surface amounts to at least 0,8mm, preferably at least 1 mm.

Preferably (may be also independent of the foregoing embodiment), the ratio between the height difference (between the highest point and the lowest point of the convex run of the receiving surface) and the length of the curved run - i.e. arc length - of the receiving surface (or length of the pv-device) amounts to at least 1/200, preferably at least 1/160.

Preferably, the printed circuit surface forms at least a portion of the receiving surface of the support. The photovoltaic device is laid upon the receiving surface of the support. Since the receiving surface is at the same time the printed circuit surface electrical contact is immediately established.

Preferably, the printed circuit surface is formed on a portion (for example on a portion of the electrical interface), which is mountable within the testing device in a detachable manner, wherein preferably the support is formed by a lower portion and an upper portion, with the upper portion comprising the printed circuit surface and being mountable to the lower portion in a detachable manner. The upper portion, which e.g. may be a printed circuit board with the printed circuit surface on its top, may be replaced by a upper portion having a different printed circuit structure. The adaption for testing photovoltaic devices having different contact structures may be easily accomplished by replacement of the portion with the printed circuit surface.

The lower portion of the support may be flat but may also have a convex shape (towards the pv-receiving area). A flexible (flat) PCB may adapt its shape when pressed against the lower portion of the support.

Preferably, the printed circuit surface is formed by a plate-shaped element, preferably by a printed circuit board. This allows to form a compact, mechanically stable and cost-effective electrical interface.

Preferably, the plate-shaped element (e.g. the printed circuit board) is flexible. This allows to bend the FlexPCB together with the photovoltaic device (according to e.g. the contour of a convex shaped support part) when pressing PCB and photovoltaic device together. The flexible plate-shaped element may be made of any flexible circuit materials as known to a person skilled in the art.

Preferably, at least one electronic component, preferably a switch (e.g. a semiconductor switch or an electromechanical relay), a sensor, a resistor, a capacity, a coil, a light source such as a light emitting diode (LED), a light sensor such as a photo-diode and/or a heating element, are mounted to the electrical interface, preferably to the printed circuit board, wherein preferably the electronic component is mounted on that surface of the electrical interface or the printed circuit board opposing the printed circuit surface. The electronic component(s) could also be inserted in local openings (holes) in the PCB. This allows to use the electrical interface for both: electrically contacting the photovoltaic device and supporting functional electrical components. Preferably, the at least one electronic component is a functional part of the measurement device. Preferably, the light source (e.g. LED) is used for illuminating the pv-device (during measurement) and/or the light sensor (e.g. photo-diode) is used to detect light emitted from the pv-device (electroluminescence) or to monitor light impinging on the pv-device.

Preferably, the electrical component is a controllable switch connected between a first printed conducting path section forming at least one electrical contact and a second printed conducting path section forming at least one electrical contact. This allows to switch contacting sections together in order to perform different kinds of measurements and/or to match with the actual size of the pv-device to be tested. Selectively switching the contacting sections also allows to measure sheet resistivity of the cell's surface (similar to busbar-to-busbar measurement).

The printed circuit surface/layer may include electronic components also for local measurements, switching or for adding resistive components to chosen contacting points.

Resistivities may be added/integrated to the printed circuit surface in order to adapt the measurement currents/voltages. Switching circuits (logical gates and amplifiers) may be added/integrated to the PC-surface in order to manually select or deactivate certain regions of the contacting system.

Preferably, the electrically insulating material of the printed circuit surface is colored dark, preferably in black. This is a preferred embodiment in connection with back-contact solar cells in order to simulate the efficiency of a solar cell embedded within a completed solar module.

Preferably, printed conducting paths which connect exposed electrical contacts of the printed circuit surface are covered with a layer of electrically insulating material, preferably of dark, particularly black color.

Preferably, the printed circuit board has a core of thermally conducting material, preferably of metal or ceramic, covered by a substrate from electrically insulating material. This allows to remove heat caused by measurement parameters (light, current) and/or to uniformly balancing temperature gradients. Alternatively, just thin FlexPCBs may be used, which do not form a thermal barrier.

Preferably, the printed circuit board (e.g. upper portion of support) is supported on a base (e.g. lower portion of the support), wherein a thermal foil is arranged between the printed circuit board and the base.

Preferably, the printed circuit surface has at least the same size as the receiving surface of the support.

Preferably, the testing device comprises a light source and/or a light detector. This allows to perform electroluminescence measurements and/or to test the performance of the pv-device. In a preferred embodiment the light source and/or the light detector are arranged on the electrical interface, preferably on the PCB.

Preferably, the testing device has two electrical interfaces for receiving the photovoltaic device in between, and wherein the exposed electrical contacts of the first interface face towards the electrical contacts of the second electrical interface.

Preferably, the flexible member, preferably a casing, more preferably a container made of a plastic envelope, is filled with a gaseous, liquid or gel-like fluid or with a granulated material for balancing the force of the forcing means.

The term member/casing may be also understood as container, envelope, package, housing, etc.. The casing may be a bag, a sack or an envelope of flexible material, e.g. a thin foil. The term 'flexible member or casing' is to be understood, that at least a portion of the member or casing is flexible. However, the flexible member/casing may also comprise at least one rigid portion connected to a flexible portion/material. The member/casing has - at least in the forcing state of the forcing means - an essentially flat surface facing towards the receiving surface or forming the receiving surface. The member/casing transmits the force exerted by the forcing means to the photovoltaic device when received by the receiving surface of the support. It is not necessary that the whole member/casing is made of flexible material. It is preferred that at least one face of the member or casing is made of flexible material.

The flexible member may define a closed volume (e.g. closed sack), which has a balancing function. In an alternate embodiment the flexible member may be also inflatable. In this case the flexible member has a balancing function and at the same time a forcing function.

For applying a uniform pressure on the pv-device a flexible container, filled with gas or liquid, may be used. The container is put on the top and/or the back of the pv-device.

When put in front of the pv-device, a transparent (glass) plate would press the flexible container onto the cell. On the flexible container may be a printed circuit surface according to an embodiment of the invention. At the back of the pv-device may be another flexible container (with wires, circuit, etc.) or any rigid structure (including or not including a printed circuit surface).

When put at the backside of the cell, the flexible container may also include a printed circuit surface. On the front side of the cell may be a rigid or flexible element (bars, glass plate, wires, foil or another flexible container) with wires, circuit, etc.

The content of the flexible casing may be thermo-regulated in order to regulate the cell's temperature.

The flexible casing may be a closed container with a constant volume or combined with a pressure (volume) regulation system. The variation of the container's volume (e.g. by a pump) may be used in order to contact and de-contact the solar cell.

Preferably, the flexible member, e.g. casing, is inflatable and has an inlet for inflating the flexible member, This allows - in an elegant way - to combine the forcing function with the balancing function. Preferably, the forcing means comprises a pump for pressurizing the inflatable member with a medium via the inlet.

Preferably, a printed circuit surface is formed on the surface of the flexible member. This allows to establish a smooth and uniform contact all over the flat surface of the pv-device.

Preferably, the flexible member is formed from a transparent material. This allows to arrange a light source and/or a light detector, which is part of the testing device beyond the flexible member.

An object of the invention is also achieved by means of a method of testing a photovoltaic device, particularly a solar cell, with a testing device according to one of the preceding embodiments, comprising the steps of:
establishing a temporary electrical connection between the electrical interface and the photovoltaic device by bringing together at least one of the exposed electrical contacts of the electrical interface with at least one of the electrical contacts of the photovoltaic device,
preferably forcing the electrical interface and the photovoltaic device against each other,
performing a test measurement, wherein preferably the test measurement is performed by applying a voltage or current to the photovoltaic device and/or by measuring the voltage or current from the photovoltaic device.

When the test procedure is completed, the pv-device is removed from the electrical interface and from the testing device and thus the temporary electrical contact of the pv-device with the electrical interface is resolved.

In the following further preferred embodiments are described, which may be combined with any of the aspects described above:
Preferably, the printed circuit surface is provided on a removable and/or exchangeable portion (support portion, base, plate, PCB, etc.) of the testing device. In order to test different metallization type pv-devices only the removable and/or exchangeable portion has to be replaced by another portion having a printed circuit surface with a different contacting structure/pattern. It is preferred that there are fixing means (screws, clips, etc.) provided in the testing device for fixing the removable and/or exchangeable portion (e.g. on a support portion).

An advantage is to use of standard methods for printed circuit fabrication for making adapted contacting layers for any kind of solar cell metallization. The proposed circuit layers are integrable into various kinds of pressing devices and are exchangeable (as wear parts) for being compatible to different cell metallization designs.

The printed circuit surface (or printed circuit layer) can have small localized contacting zones with improved electrical contacting properties. They may e.g. be plated with a gold layer.

Printed circuit layer according to the invention may be put on the backside and/or the top side of the solar cell and may be put on hard or flexible, flat or bent substrates. The surface/layer can be colored, reflective or transparent and may be thermally insulated or conductive in order to assure the correct temperature of the pv-device.

Further embodiments of the invention are indicated in the figures and in the dependent claims. The list of reference marks forms part of the disclosure. The invention will now be explained in detail by the drawings. In the drawings:
Fig. 1 shows an embodiment of a testing device;
Fig. 2 shows the support with the electrical interface,
Fig. 3 shows in a cross-section a possible structure of the electrical interface,
Figs. 4 to 10 show different embodiments of a testing device,
Fig. 11 shows a cutout of the printed circuit surface,
Fig. 12 shows a cutout of an example of a printed circuit surface,
Fig. 13 shows two embodiments of the electrical interface,
Fig. 14 shows a further embodiment,
Fig. 15 shows in a cross-sectional view a flexible member formed completely from electrically insulating material,
Fig. 16 shows in a cross-sectional view a longitudinal flexible member in form of a jacket surrounding a strand (reinforcing element),
Fig. 17 shows a preferred embodiment of a testing device comprising tensioning means for tensioning the flexible member.

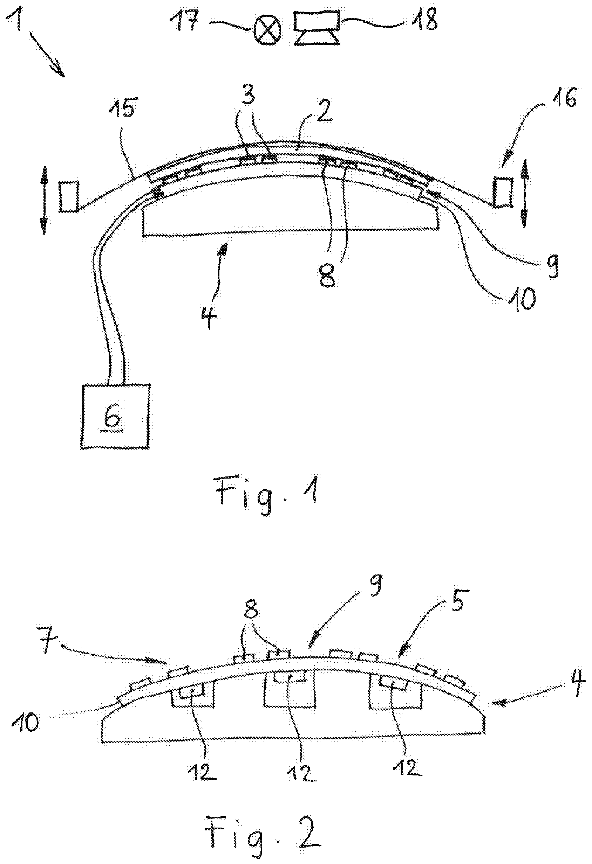

Fig. 1 shows a testing device 1 for testing a flat photovoltaic device 2, particularly a solar cell element, a solar cell and/or a string of solar cells, having electrical contacts 3 on at least one of its flat surfaces. The testing device 1 comprises a support 4 having a receiving surface 5 for receiving the photovoltaic device 2, a measurement device 6 (e.g. voltmeter, ampere-meter, voltage source and/or current source), and at least one electrical interface 7 having exposed electrical contacts 8 for abutting against the electrical contacts 3 of the photovoltaic device 1 (when pv-device is received by the receiving surface 5), in order to establish a temporary electrical connection.

The electrical interface 7 is connected to the measurement device 6, in order to establish an electrical connection between pv-device 2 and measurement device 6. The electrical interface 7 comprises a printed circuit surface 9 with the exposed electrical contacts 8 formed by printed conducting structures, preferably gold plating, on a surface of electrically insulating material.

The support 4 may comprise a lower portion 4a and an upper portion carrying the printed circuit surface 9. In the embodiments of Fig. 1 and 2 the upper portion of the support 4 is a printed circuit board 10.

The testing device 1 further comprises a forcing means 16 for forcing the printed circuit surface 9 and the photovoltaic device 2 against each other when the photovoltaic device 2 is received by the support 4. The forcing means 16 may comprise a holding device for holding a flexible member 15, e.g. a wire, and a drive for driving the holding device in up- and down direction.

In an alternative embodiment, the top part (comprising flexible wires 15) may be fixed, and the bottom part (support 4) is movable (vertically) up towards the flexible wires 15. The drive moving the bottom part is then part of the forcing means.

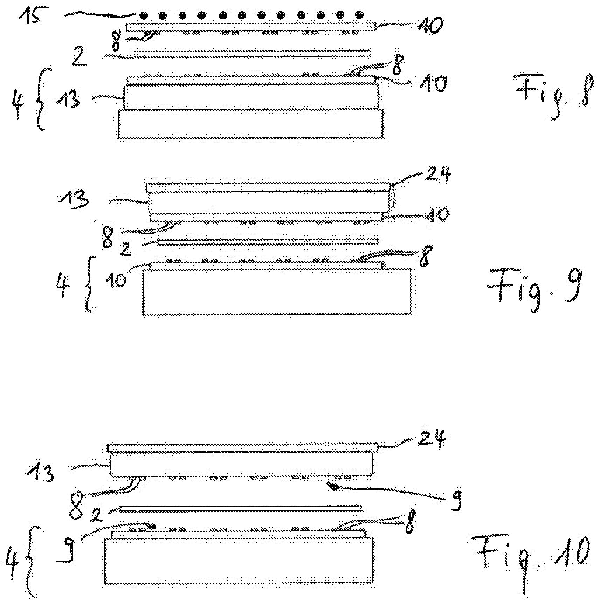

The flexible member 15 is preferably made of electrically insulating material (e.g. plastic or nylon wire) and is used for transferring the force of the forcing means 16 to the photovoltaic device 2. Alternatively, flexible member 15 may act upon the electrical interface 7 (see Fig. 8).

The flexible member 15 is preferably at least partially transparent, in order to let light passing from and towards the pv-device 2. The testing device 1 comprises a light source 17 and/or a light detector 18 (e.g. a camera) facing towards the pv-device receiving area, in order to test the performance of the pv-device and/or to perform photo- or electroluminescence measurements.

The at least one flexible wire 15 may form a grid or a mesh work.

The flexible wire 15 continuously extends above the receiving surface 5 over at least one edge of the receiving surface 5, in Fig. 1 over two opposing edges.

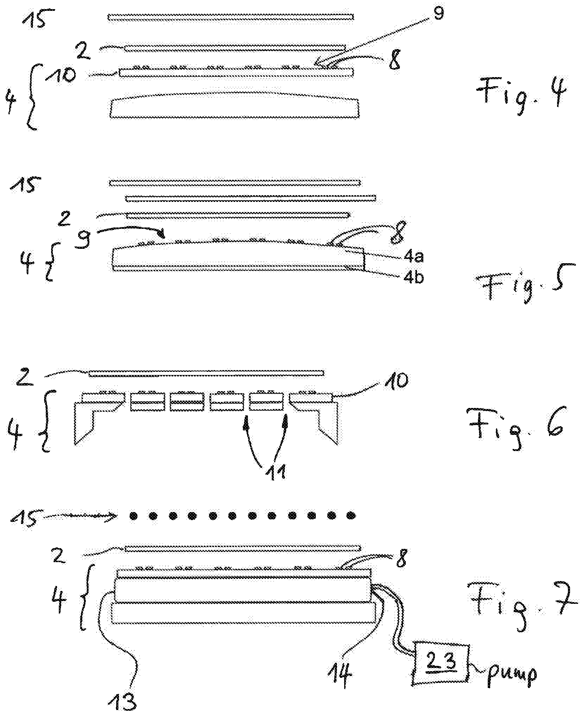

Alternatively the forcing means 16 may comprise suction means (e.g. vacuum reservoir or pump 23), wherein preferably the printed circuit surface 9 has a plurality of suction openings 11 chargeable with underpressure (Fig. 6).

As can be seen from Figs. 1, 2 and 5 the support 4 may have a convex shape defining a convex receiving surface 5.

The printed circuit surface 9 forms the receiving surface 5 of the support 4.

The printed circuit surface 9 is formed on a portion (e.g. a PCB), which is detachably mounted within the testing device 1. In the embodiment of Fig. 1 and 2 the support 4 is formed by a lower portion 4a and an upper portion 4b, with the upper portion (in the form of a PCB 10) comprising the printed circuit surface 9 and being detachably mounted to the lower portion 4a.

As already mentioned the printed circuit surface 9 may be formed by a plate-shaped element, preferably by a printed circuit board 10 (Fig. 1, 2).

As indicated in Fig. 4 the printed circuit board 10 is flexible and adapts with the force exerted by forcing means 16 onto the pv-device 2 to the bent shape shown in Fig. 1.

As can be seen from Fig. 2 at least one electronic component 12, preferably a semiconductor switch, a sensor, a resistor, a capacity, a coil, and/or a heating element, is mounted to the printed circuit board 10. In Fig. 2 the electronic component 12 is mounted on that surface of the printed circuit board 10 opposing the printed circuit surface 9. In the lower portion 4a of the support 4 recesses may be provided to accommodate the electrical components 12.

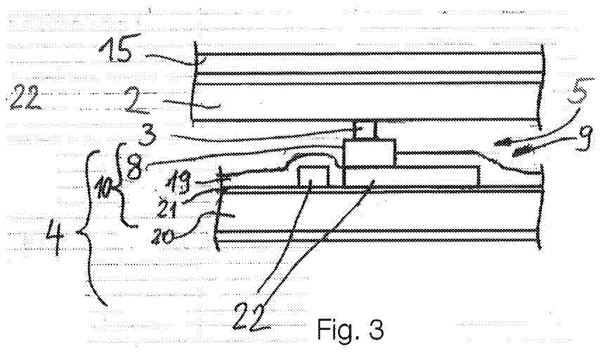

Fig 3 shows in a cross-sectional view a portion of a printed circuit layer 9. The printed circuit board is formed by a metallic (or ceramic) core 20 which may be sandwiched by layers of electrically insulating material. It would be also possible that there is an electrically insulating layer only on the top of the core 20. The (metallic) core 20 is covered by a substrate 21 of electrically insulating material. On that substrate conducting paths are printed, preferably from copper. An exposed electrical contact 8 is formed by an elevated copper structure extending upwards from the conducting path 22. The exposed electrical contact is preferably covered by a plating of highly conductive material, such as gold. The printed conducting paths 22 are covered by a layer 19 of electrically insulating (preferably also: thermally conductive) material. This allows to selectively contact the contacts 3 of pv-device 2 by the exposed electrical contacts 8 of the electrical interface 7 without producing short-circuits. A thermal foil 25 may be sandwiched between the PCB 10 and the lower portion 4a of support 4, in order to enhance the thermal contact between pv-device 2 and support 4.

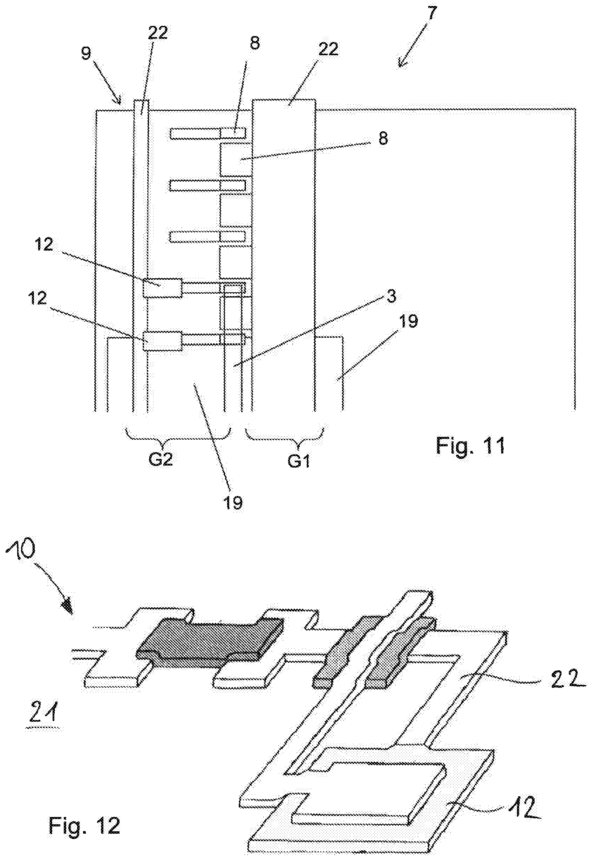

Fig. 11 shows a possible printed circuit structure. A first (left) and second (right) conducting path 22 may be used to contact an electrical contact 3 (here: a finger 3) on the back-side of a pv-device 2. The first conducting path 22 may be used for voltage measurement (small contact area of the exposed electrical contacts 8 and small width of the conducting path 22) and the second conducting path 22 may be used for current measurements (larger contact area of the exposed electrical contacts 8 and large width of the conducting path 22).

In a preferred embodiment, therefore, exposed electrical current contacts 8 have a larger contact area than exposed electrical voltage contacts 8.

In a further preferred embodiment a current measurement conducting path 22 has a larger width than a voltage measurement path 22.

Thus, a first group G1 of exposed electrical contacts (current) has a larger, contact area, preferably at least twice as large, than a second group G2 of exposed electrical contacts (voltage). As can be seen from Fig. 11 exposed electrical contacts 8 of the first group G1 and exposed electrical contacts 8 of the second group G2 are alternately arranged one after another along a (straight) line (overlapping with an finger-like electrical contact 3 of the pv-device 2 in the measurement position).

In the present embodiment exposed electrical (voltage) contacts 8 are connected to the (left) conducting path 22 via electrical components 12 that are resistors (e.g. applied by means of thick film printing). The resistors limit the current in the vicinity of the source, allowing a shorter and more exact measurement step (because of a smaller/shorter voltage drop).

The resistors prevent the current circulating from one exposed electrical (voltage) contact 8 to another and thus reduce the impact of contact resistivity. Additionally, each resistor equalizes the weight of each voltage measurement and assures that the overall voltage measurement corresponds to the average of all local voltage measurements.

As indicated in Fig. 11 the conducting paths 22 are covered by electrically insulating material, preferably by a layer 19. The conducting paths 22, interconnecting the exposed electrical contacts 8, do not touch the photovoltaic device 2 during the test measurement, which leads to more precise test results.

Fig. 4 to 10 show alternative embodiments of arrangements between support 4, pv-device 2, printed circuit surface 9 and forcing means 16, 23 or force transmission elements 15, 13. As can be seen especially from Fig. 4 the printed circuit surface 9 may be detachable from the testing device 1 (namely from the lower part 4a of the support 4).

In Fig. 4 the pv-device 2 will be sandwiched between flexible wires (top) and a flexible PCB 10 (bottom) forming at the same time the receiving surface 5. The lower portion 4a of the support 4 is convex shaped towards the pv-device 2.

In Fig. 5 the printed circuit surface 9 is formed directly on a convex shaped surface of support 4 (i.e. directly printed on the bent chuck).

In Figs. 8 to 10 the pv-device 2 is sandwiched between two printed circuit surfaces 9 and thus contacted from both sides.

In the embodiments of Figs. 7 to 10 the testing device 1 comprises at least one flexible member 13, preferably a casing, more preferably a container made of a plastic envelope, which member 13 is filled with a gaseous, liquid or gel-like fluid or with a granulated material for balancing the force of the forcing means.

The flexible member 13 (or casing) is inflatable in the embodiment of Fig. 7 (e.g. as a pumped plastic bag) and has an inlet 14 for inflating the member 13. A pump 23 connected to the inlet 14 provides a medium flow into and/or out of the member 13. Due to the volume/pressure change the electrical interface 7 may be pressed against the pv-device 2. Alternatively it would be possible to press the pv-device 2 against an electrical interface 7 (Fig. 8 to 10). The top wire 15 grid is drawn at 90° in Figs. 7 and 8 with respect to the other figures.

As in Fig. 10 the printed circuit surface 9 may also formed directly on the surface of the flexible member 13.

In order to prevent shading (especially in the embodiments of Fig. 9 and 10, where the casing faces towards the top surface of the pv-device) the flexible member 13 may be partially or completely formed from a transparent material.

In Figs. 9 and 10 a transparent (glass) plate is arranged above the flexible member 13 and transmits force to the sandwich structure of the measurement condition. Light can then pass the top part of that sandwich structure to reach the pv-device 2.

Fig. 12 shows as an example a conducting structure of a printed circuit board 10 with conducting paths 22 printed on a substrate 21 and with passive functional components (capacity, resistor) 12 integrated in the layered structure.

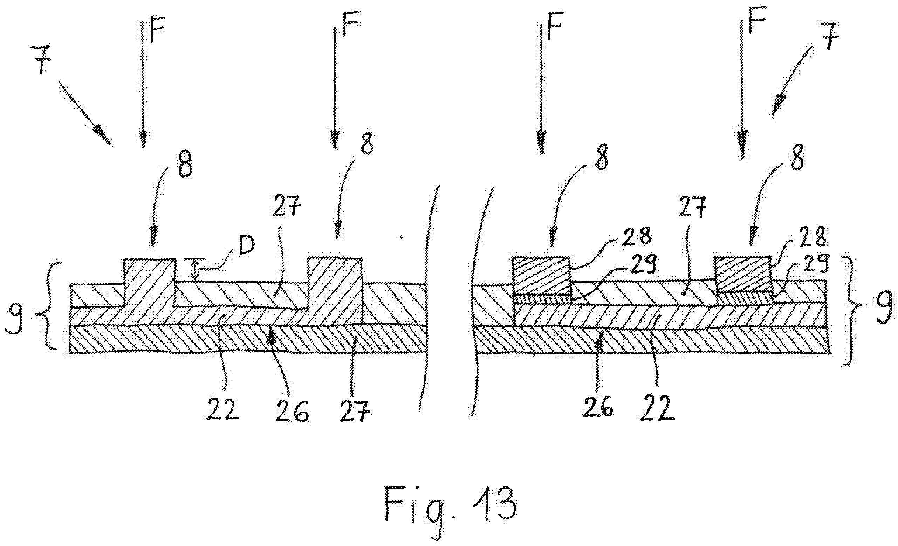

Fig. 13 shows two embodiments of the electrical interface 7. In the first embodiment of Fig. 13 (left part) exposed electrical contacts 8 are directly formed by the printed conducting structures 26 of the printed circuit surface 9. The exposed electrical contacts 8 may be made by local material growth, such as anodization, e.g. using copper. The exposed electrical contacts 8 are in electrical communication with conducting paths 22 extending below electrically insulating material 27. The upper layer of electrically insulating material 27 (Fig. 13) may be a solder resist. The bottom layer of electrically insulating material 27 (Fig. 13) may be an insulating PCB substrate. These conducting paths 22 may electrically connect exposed electrical contacts 8 with each other and/or an exposed electrical contact 8 with the measurement device 6.

In the second embodiment of Fig. 13 (right part) exposed electrical contacts 8 are each formed by an electrically conducting member 28 that is connected to the printed conducting structure 26 of the printed circuit surface 9 by means of solder 29 (alternatively an electrically conducting adhesive or electroplating would also be possible for connection).

In both embodiments the electrical interface 7 comprises a printed circuit surface 9 with the exposed electrical contacts 8 formed by printed conducting structures 26 on electrically insulating material 27.

The exposed electrical contacts 8 are each connected to the electrically insulating material 27 in an immovable manner, such that each exposed electrical contact 8 as a whole is immovable (i.e. has no moveable parts) with respect to the electrically insulating material 27. In the first embodiment of Fig. 3 (left part) the printed conducting structure 26 directly forms the exposed electrical contacts 9. In the second embodiment of Fig. 3 (right part) electrically conductive members 28 form the exposed electrical contacts 8.

As can be seen, the exposed electrical contacts 8 are capable to transmit the force F, which results from pressing the photovoltaic device 2 and the electrical interface 7 together, to the conducting path 22 and/or to the electrically insulating material 27 of the printed circuit surface 9. The force path thereby extends from the upper contact surface (disposed to touch an electrical contact of the pv-device) of the exposed electrical contact 8 towards that portion of the exposed electrical contact 8 that is in bottom touch with the conducting path 22 and/or the electrically insulating material 27 of the printed circuit surface 9. The force path extend essentially perpendicular to the printed circuit surface 9, i.e. between opposing end surfaces of an exposed electrical contact 8. The force path thus runs essentially parallel to the current and/or voltage path/direction within the exposed electrical contact 8.

It is preferred that the contact surface (uppermost surface coming into contact or touch with the pv-device 2) of the exposed electrical contacts 8 is elevated with respect to the electrically insulating material 27, preferably by a height distance D not exceeding 2mm, preferably not exceeding 1 mm.

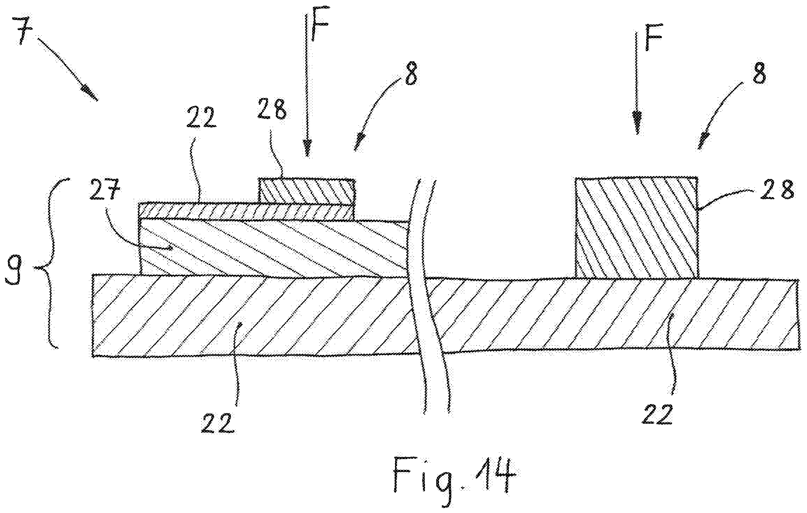

Fig. 14 shows a further embodiment of the present invention. The left part of Fig. 14 (first portion of a printed circuit surface 9) shows an exposed electrical contact 8 that may be used for voltage measurements. The contact 8 is formed by an electrically conductive member 28 that is connected to a conducting path 22 of the printed circuit surface 9. The conducting path 22 extends on an electrically insulating material 27. A further (lower) conducting path 22 forms the basis of the printed circuit surface 9. In the right part of Fig. 14 (second portion of the same printed circuit surface 9) the path 22 carries an electrically conductive member 28 that forms an exposed electrical contact 8 that may be used for current measurements. The lower conducting path 22 is electrically insulated from the upper conducting path 22 by means of the electrically insulating material/layer 27. F denotes the force exerted on the exposed electrical contacts 8 when the pv-device 2 and the electrical interface 7 are pressed together.

A method of testing a photovoltaic device 2, particularly a solar cell, with a testing device 1 according to one of the preceding embodiments, comprises the steps of:
establishing a temporary electrical connection between the electrical interface 7 and the photovoltaic device 2 by bringing together the exposed electrical contacts 8 of the electrical interface 7 with the electrical contacts 8 of the photovoltaic device 2,
preferably forcing the electrical interface 7 and the photovoltaic device 2 against each other by forcing means 15, 16, 11, 23;
performing a test measurement, wherein preferably the test measurement is performed by applying a voltage or current to the photovoltaic device 2 and/or by measuring the voltage or current from the photovoltaic device 2.

In a further embodiment it would be possible to contact the bottom metallization of a photovoltaic device 2 by means of a printed circuit surface 9 as described above and the top metallization of the same photovoltaic device 2 by means of flexible wires of electrically conducting material. The latter may be also connected to the measurement device 6.

It should be also mentioned that it is not relevant whether the support 4 moves towards the flexible wires 15 or the flexible wires 15 move towards the support 4 when pressing the photovoltaic device in between.

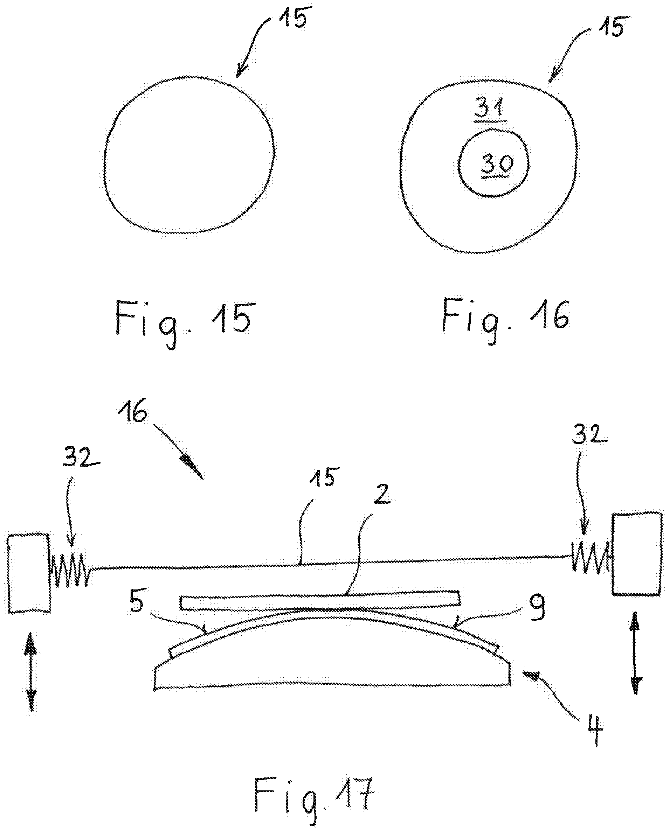

In the embodiment of Fig. 15 the flexible member is completely formed from electrically insulating material. Here the flexible member may be a wire, e.g. a nylon wire that may comprise reinforcement fibres such as glass fibres.

Fig. 16 shows a further embodiment, where the flexible member 15 is formed by a jacket 31 of electrically insulating material, the jacket 31 surrounding at least one strand 30. The strand 30 may or may not be of electrically insulating material. It is preferred that the tensile strength of the at least one strand 30 is higher than the tensile strength of the jacket 31. The strand 30 may be e.g. a (glass) fibre, carbon fibre or a metal strand.

Fig. 17 shows a preferred embodiment, where the flexible member 15 has longitudinal extension. The flexible member 15 and/or a longitudinal reinforcing element 30 (see Fig. 16) connected to the flexible member 15 is tensioned in the direction of the longitudinal extension of the flexible member 15. The tension in the flexible member 15 and/or in the reinforcing element 30 is higher than 10 N, preferably higher than 30 N. Fig. 17 shows that the flexible member 15 has a straight run when not being in contact with the photovoltaic device 2.

The testing device 1 comprises tensioning means 32 acting on the flexible member 15 in a direction of the longitudinal extension of the flexible member 15. Tensioning means 32 may be or comprise at least one spring element, an actuator (such as a cylinder drive) and/or transmission means such as a lever or a bobbin.

As can be seen from Fig. 1 and 17 the testing device 1 is adapted to receive the photovoltaic device 2 between the printed circuit surface 9 and the flexible member 15. The double arrows in Fig. 17 indicate that the flexible member(s) and the support 4 are movable with respect to each other, in order to sandwich the pv-device 2. Here, the flexible member(s) 15 may be moved towards a (stationary) support 4 or the support 4 may be moved towards a (stationary) flexible member(s) 15. Also a movement of both, support and flexible member, would be possible.

The printed circuit surface 9 is convex shaped towards the at least one flexible member 15.

In order to reach the measurement position, the flexible member 15 (in Fig. 17) moves towards the photovoltaic device 2, abuts against the first (here: upper) side of the pv-device and forces the pv-device 2 (with its second side) against the printed circuit surface 9.

It becomes apparent from Fig. 17, that the testing device 1 is adapted such that - in the measurement position - on the first side of the photovoltaic device 2 only the electrically insulating material of the flexible member 15 abuts against the photovoltaic device 2. The second side of the photovoltaic device 2 is electrically contacted by the printed circuit surface 9. Such a construction guarantees that the first (here: upper) side of the photovoltaic device 2 is - also in the measurement position - electrically un-coupled from the testing device 1 or from any of its parts.

The flexible member 15 of Fig. 17 has longitudinal (wire-like) shape. The flexible member 15 extends freely at least in its abutting section, which in the abutting (or measurement) position of the flexible member 15 abuts against the photovoltaic device 2.

The invention is not restricted to these embodiments. Other variants will be obvious for the person skilled in the art and are considered to lie within the scope of the invention as formulated in the following claims.

**List of reference signs**

| | | | |
|---|---|---|---|
| 1 | testing device | 27 | electrically insulating material |
| 2 | photovoltaic device | 28 | electrically conducting member |
| 3 | electrical contacts of photovoltaic device 2 | 29 | solder |
| | | 30 | strand |
| 4 | support | 31 | jacket |
| 4a | lower portion of support 4 | 32 | tensioning means |
| 4b | upper portion of support 4 | D | distance between the contact surface of the exposed electrical contact 8 and the upper surface of the electrically insulating material 27 |
| 5 | receiving surface | | |
| 6 | measurement device | | |
| 7 | electrical interface | | |
| 8 | exposed electrical contacts of electrical interface 7 | F | force acting upon exposed electrical contacts 8 |
| 9 | printed circuit surface | G1 | first group of exposed electrical contacts 8 |
| 10 | printed circuit board | | |
| 12 | electronic component | G2 | second group of exposed electrical contacts 8 |
| 13 | flexible member, preferably casing | | |
| 14 | inlet of flexible member 13 | | |
| 15 | flexible member | | |
| 16 | forcing means | | |
| 17 | light source | | |
| 18 | light detector | | |
| 19 | layer of electrically insulating material | | |
| 20 | metallic or ceramic core | | |
| 21 | substrate of electrically insulating material | | |
| 22 | conducting path | | |
| 23 | pump | | |
| 24 | transparent plate, preferably glass plate | | |
| 25 | thermal foil | | |
| 26 | printed conducting structures | | |

## Claims

1. A testing device (1) for testing a photovoltaic device (2), particularly a solar cell element, a solar cell and/or a string of solar cells, having electrical contacts (3) on at least one of its flat surfaces, the testing device (1) comprising:
- a support (4) having a receiving surface (5) for receiving the photovoltaic device (2),
- at least one measurement device (6),
- at least one electrical interface (7) having exposed electrical contacts (8) for abutting against at least one of the electrical contacts (3) of the photovoltaic device (2), in order to establish a temporary electrical connection,
- forcing means (16) for forcing the electrical interface (7) and the photovoltaic device (2) against each other when the photovoltaic device (2) is received by the support (4),
wherein the electrical interface (7) is connected to the measurement device (6), **characterized in that**
the electrical interface (7) comprises a printed circuit surface (9)
formed by printed conducting structures (26) on electrically insulating material (27) and that the testing device (1) comprises at least one flexible member (13, 15) of electrically insulating material, the flexible member (13, 15) cooperating with or forming the forcing means (16) to force the electrical interface (7) and the photovoltaic device (2) against each other.

2. A testing device according to claim 1, **wherein** at least one exposed electrical contact (8), preferably some or all of the exposed electrical contacts (8), is/are connected to the electrically insulating material (27) in an immovable manner, such that the exposed electrical contact (8) as a whole is immovable with respect to the electrically insulating material (27), **and/or wherein** at least one of the exposed electrical contacts (8) is formed by the printed conducting structures (26) of the printed circuit surface (9), preferably by gold-plated contacts.

3. A testing device according to one of the preceding claims, **wherein** at least one of the exposed electrical contacts (8) is formed by an electrically conducting member (28) that is immovably connected to a printed conducting structure (26) of the printed circuit surface (9), preferably by means of solder (29) or electrically conducting adhesive, **and/or wherein** the contact surface of exposed electrical contacts (8) for touching an electrical contact (3) of the photovoltaic device (2) is elevated with respect to the electrically insulating material (27), preferably by a distance (D) not exceeding 2mm, preferably not exceeding 1 mm.

4. A testing device according to any one of the preceding claims, **wherein** the forcing means (16) is adapted for forcing the printed circuit surface (9) and the photovoltaic device (2) against each other when the photovoltaic device (2) is received by the support (4), **and/or wherein** the support (4) has a convex shape defining a convex receiving surface (5).

5. A testing device according to any one of the preceding claims, **wherein** exposed electrical contacts (8) are interconnected by a conducting path (22) of the printed circuit surface (9), the conducting path (22) being at least locally connected to the electrically insulating material (27), wherein preferably a first group (G1) of exposed electrical contacts (8) has a larger contact area, preferably at least twice as large, than a second group (G2) of exposed electrical contacts (8).

6. A testing device according to any one of the preceding claims, **wherein** the electrical interface (7) is mountable within the testing device (1) in a detachable manner, preferably the support (4) having a lower portion (4a) and an upper portion (4b), with the upper portion (4b) comprising the printed circuit surface (9) and being mountable to the lower portion (4a) in a detachable manner, **and/or wherein** at least one electronic component (12), preferably a switch, a sensor, a resistor, a capacity, a coil, and/or a heating element, is mounted to the electrical interface (7), preferably to the printed circuit board (10), wherein preferably the electronic component (12) is mounted on that surface of the electrical interface (7) opposing the printed circuit surface (9).

7. A testing device according to any one of the preceding claims, **wherein** the printed circuit surface (9) is formed by a plate-shaped element, preferably by a printed circuit board (10), the plate-shaped element being preferably flexible, **and/or wherein** the printed circuit surface (9) is provided on a removable and/or exchangeable portion of the testing device (1), wherein preferably there are fixing means, such as screws, clips, etc., provided in the testing device (1) for fixing the removable and/or exchangeable portion.

8. A testing device according to any one of the preceding claims, **wherein** the flexible member (13, 15) is at least partially transparent, wherein preferably the electrically insulating material of the flexible member (13, 15) is preferably completely transparent, **and/or wherein** the flexible member (13, 15) is adapted to directly touch or to snuggle against the photovoltaic device (2) in the measurement position **and/or wherein** the flexible member (13, 15) continuously extends above the receiving surface over at least one edge of the receiving surface, preferably over two opposing edges.

9. A testing device according to any one of the preceding claims, **wherein** the flexible member (15) has longitudinal extension and wherein the flexible member (15) and/or a longitudinal reinforcing element (30) connected to the flexible member (15) is tensioned in the direction of the longitudinal extension of the flexible member (15), wherein preferably the tension in the flexible member (15) and/or in the reinforcing element (30) is higher than 10 N, preferably higher than 30 N, wherein preferably the flexible member (15) has a straight run when not being in contact with the photovoltaic device (2) and/or preferably the testing device (1) comprises tensioning means (32) acting on the flexible member (15) in a direction of the longitudinal extension of the flexible member (15).

10. A testing device according to any one of the preceding claims, **wherein** the flexible member (15) is a wire, **or wherein** the flexible member (15) is a flexible nylon wire, **or wherein** the at least one flexible member is a flexible foil or layer, **or wherein** the flexible member (15) comprises a jacket (31) of electrically insulating material, the jacket (31) at least partially surrounding at least one strand (30), wherein preferably the tensile strength of the at least one strand (30) is higher than the tensile strength of the jacket (31).

11. A testing device according to any one of the claims 1 to 9, **wherein** the flexible member (13), preferably a casing, more preferably a container comprising a plastic envelope, is filled with a gaseous, liquid or gel-like fluid or with a granulated material for balancing the force of the forcing means (16) **and/or wherein** the flexible member (13) is inflatable and has an inlet (14) for inflating the flexible member (13).

12. A testing device according to one of the preceding claims, **wherein** the printed circuit surface (9) is formed on the surface of the flexible member (13), **and/or wherein** the printed circuit surface (9) is convex shaped towards the at least one flexible member (13, 15), **and/or wherein** the flexible member (13) is formed from a transparent material.

13. A testing device according to any one of the preceding claims, **wherein** the printed circuit surface (9) forms at least a portion of the receiving surface of the support (4) **and/or wherein** the printed circuit surface (9) has at least the same size as the receiving surface of the support (4).

14. A testing device according to any one of the preceding claims, **wherein** the testing device (1) is adapted to receive the photovoltaic device (2) between the printed circuit surface (9) and the flexible member (13, 15) **and/or wherein** the testing device (1) is adapted such that - in the measurement position - on the first side of the photovoltaic device (2) only the electrically insulating material of the flexible member (15) abuts against the photovoltaic device (2) and that the second side of the photovoltaic device (2) is electrically contacted by the printed circuit surface (9), wherein the first side of the photovoltaic device (2) is - in the measurement position - electrically un-coupled from the testing device (1) or from any of its parts.

15. Method of testing a photovoltaic device (2), particularly a solar cell element, a solar cell and/or a string of solar cells, with a testing device (1) according to one of the preceding claims, comprising the steps of:
establishing a temporary electrical connection between the electrical interface (7) and the photovoltaic device (2) by bringing together at least one of the exposed electrical contacts (8) of the electrical interface (7) with at least one of the electrical contacts (8) of the photovoltaic device (2),
preferably forcing the electrical interface (7) and the photovoltaic device (2) against each other,
performing a test measurement, wherein preferably the test measurement is performed by applying a voltage or current to the photovoltaic device (2) and/or by measuring the voltage or current from the photovoltaic device (2).

## Patentansprüche

1. Testvorrichtung (1) zum Testen einer fotovoltaischen Vorrichtung (2), insbesondere ein Solarzellenelement, eine Solarzelle und/oder eine Kette von Solarzellen, die elektrische Kontakte (3) auf mindestens eine ihrer ebenen Flächen haben, wobei die Testvorrichtung (1) umfasst:
- eine Stütze (4), die eine Aufnahmefläche (5) zum Aufnehmen der fotovoltaischen Vorrichtung (2) hat,
- mindestens eine Messvorrichtung (6),
- mindestens eine elektrische Schnittstelle (7), die freigelegte elektrische Kontakte (8) zum Anstoßen an mindestens einen der elektrischen Kontakte (3) der fotovoltaischen Vorrichtung (2) hat, um eine temporäre elektrische Verbindung herzustellen,
- Zwangseinrichtung (16) zum Zwingen der elektrischen Schnittstelle (7) und der fotovoltaischen Vorrichtung (2) gegeneinander, wenn die fotovoltaische Vorrichtung (2) von der Stütze (4) aufgenommen wird,
wobei die elektrische Schnittstelle (7) mit der Messvorrichtung (6) verbunden ist, **dadurch gekennzeichnet, dass**
die elektrische Schnittstelle (7) eine Leiterplattenfläche (9) umfasst, die durch gedruckte leitende Strukturen (26) auf elektrisch isolierendem Material (27) gebildet ist, und dass die Testvorrichtung (1) mindestens ein flexibles Element (13, 15) von elektrisch isolierendem Material umfasst, wobei das flexible Element (13, 15) mit der Zwangseinrichtung (16) zusammenwirkt oder diese bildet, um die elektrische Schnittstelle (7) und die fotovoltaische Vorrichtung (2) gegeneinander zu drücken.

2. Testvorrichtung nach Anspruch 1, wobei mindestens ein freigelegter elektrischer Kontakt (8), vorzugsweise einige oder alle freigelegten elektrischen Kontakte (8), mit dem elektrisch isolierenden Material (27) in einer unbeweglichen Weise verbunden ist/sind, derart dass der freigelegte elektrische Kontakt (8) als Ganzes gegenüber dem elektrisch isolierenden Material (27) unbeweglich ist, und/oder wobei mindestens einer der freigelegten elektrischen Kontakte (8) durch die gedruckten leitenden Strukturen (26) der Leiterplattenfläche (9) gebildet wird, vorzugsweise durch gold-plattierte Kontakte.

3. Testvorrichtung nach einem der vorherigen Ansprüche, wobei mindestens einer der freigelegten elektrischen Kontakte (8) durch ein elektrisch leitendes Element (28) gebildet wird, das unbeweglich mit einer gedruckten leitenden Struktur (26) der Leiterplattenfläche (9) verbunden ist, vorzugsweise mittels Lot (29) oder elektrisch leitendem Klebstoff, und/oder wobei die Kontaktfläche von freigelegten elektrischen Kontakten (8) zum Berühren eines elektrischen Kontaktes (3) der fotovoltaischen Vorrichtung (2) gegenüber dem elektrisch isolierenden Material (27) angehoben ist, vorzugsweise um einen Abstand (D), der 2 mm nicht übersteigt, vorzugsweise 1 mm nicht übersteigt.

4. Testvorrichtung nach einem der vorherigen Ansprüche, wobei die Zwangseinrichtung (16) dafür ausgelegt ist, die Leiterplattenfläche (9) und die fotovoltaische Vorrichtung (2) gegeneinander zu pressen, wenn die fotovoltaische Vorrichtung (2) von der Stütze (4) aufgenommen wird, und/oder wobei die Stütze (4) eine konvexe Form hat, die eine konvexe Aufnahmefläche (5) definiert.

5. Testvorrichtung nach einem der vorherigen Ansprüche, wobei freigelegte elektrische Kontakte (8) durch eine Leiterbahn (22) der Leiterplattenfläche (9) miteinander verbunden sind, wobei die Leiterbahn (22) zumindest lokal mit dem elektrisch isolierenden Material (27) verbunden ist, wobei vorzugsweise eine erste Gruppe (G1) von freigelegten elektrischen Kontakten (8) eine größere Kontaktfläche hat, vorzugsweise mindestens zweimal so groß wie eine zweite Gruppe (G2) von freigelegten elektrischen Kontakten (8).

6. Testvorrichtung nach einem der vorherigen Ansprüche, wobei die elektrische Schnittstelle (7) innerhalb der Testvorrichtung (1) in einer lösbaren Weise befestigt werden kann, wobei die Stütze (4) vorzugsweise einen unteren Teil (4a) und einen oberen Teil (4b) hat, wobei der obere Teil (4b) die Leiterplattenfläche (9) umfasst und an dem unteren Teil (4a) in einer lösbaren Weise montiert werden kann, und/oder wobei mindestens eine elektronische Komponente (12), vorzugsweise ein Schalter, ein Sensor, ein Widerstand, eine Kapazität, eine Spule und/oder ein Heizelement, auf der elektrischen Schnittstelle (7) montiert ist, vorzugsweise auf der Leiterplatte (10), wobei vorzugsweise die elektronische Komponente (12) auf dieser Fläche der elektrischen Schnittstelle (7) montiert ist, die der Leiterplattenfläche (9) gegenüberliegt.

7. Testvorrichtung nach einem der vorherigen Ansprüche, wobei die Leiterplattenfläche (9) durch ein plattenförmiges Element gebildet wird, vorzugsweise durch eine Leiterplatte (10), wobei das plattenförmige Element vorzugsweise flexibel ist, und/oder wobei die Leiterplattenfläche (9) auf einem abtrennbaren und/oder austauschbaren Teil der Testvorrichtung (1) vorgesehen ist, wobei es vorzugsweise Befestigungsmittel gibt, wie zum Beispiel Schrauben, Clips, usw., die in der Testvorrichtung (1) zum Befestigen des abtrennbaren und/oder austauschbaren Teils vorgesehen sind.

8. Testvorrichtung nach einem der vorherigen Ansprüche, wobei das flexible Element (13, 15) zumindest teilweise transparent ist, wobei vorzugsweise das elektrische isolierende Material des flexiblen Elementes (13, 15) vorzugsweise vollständig transparent ist, und/oder wobei das flexible Element (13, 15) dafür ausgelegt ist, die fotovoltaische Vorrichtung (2) direkt zu berühren oder sich an dieselbe in der Messposition anzudrücken und/oder wobei das flexible Element (13, 15) sich kontinuierlich oberhalb der aufnehmenden Fläche über mindestens eine Kante der aufnehmenden Fläche erstreckt, vorzugsweise über zwei gegenüberliegende Kanten.

9. Testvorrichtung nach einem der vorherigen Ansprüche, wobei das flexible Element (15) eine Längsausdehnung hat und wobei das flexible Element (15) und/oder ein längliches Verstärkungselement (30), das mit dem flexiblen Element (15) verbunden ist, in Richtung der Längsausdehnung des flexiblen Elementes (15) gespannt ist, wobei die Spannung im flexiblen Element (15) und/oder im Verstärkungselement (30) vorzugsweise größer als 10 N, vorzugsweise größer als 30 N ist, wobei vorzugsweise das flexible Element (15) einen geraden Verlauf hat, wenn es nicht gerade in Kontakt mit der fotovoltaischen Vorrichtung (2) ist, und/oder die Testvorrichtung (1) umfasst vorzugsweise Spannvorrichtungen (32), die auf das flexible Element (15) in einer Richtung der Längsausdehnung des flexiblen Elementes (15) wirken.

10. Testvorrichtung nach einem der vorherigen Ansprüche, wobei das flexible Element (15) ein Draht ist, oder wobei das flexible Element (15) ein flexibler Nylondraht ist, oder wobei das mindestens eine flexible Element ein flexible Folie oder Schicht ist, oder wobei das flexible Element (15) eine Ummantelung (31) des elektrisch isolierenden Materials umfasst, wobei die Ummantelung (31) zumindest teilweise mindestens einen Strang (30) umgibt, wobei vorzugsweise die Zugfestigkeit des mindestens einen Strangs (30) größer als die Zugfestigkeit der Ummantelung (31) ist.

11. Testvorrichtung nach einem der Ansprüche 1 bis 9, wobei das flexible Element (13), vorzugsweise ein Gehäuse, besser ein Behälter, der eine Kunststoffumhüllung umfasst, mit einem gasförmigen, flüssigen oder gelartigen Fluid gefüllt ist oder mit einem granulierten Material zum Ausgleichen der Kraft der Zwangseinrichtung (16), und/oder wobei das flexible Element (13) aufblasbar ist und einen Einlass (14) zum Aufblasen des flexiblen Elementes (13) hat.

12. Testvorrichtung nach einem der vorherigen Ansprüche, wobei die Leiterplattenfläche (9) auf der Fläche des flexiblen Elementes (13) gebildet ist, und/oder wobei die Leiterplattenfläche (9) konvex zu dem mindestens einen flexiblen Element (13, 15) geformt ist, und/oder wobei das flexible Element (13) aus einem transparenten Material gebildet ist.

13. Testvorrichtung nach einem der vorherigen Ansprüche, wobei die Leiterplattenfläche (9) zumindest einen Teil der aufnehmenden Fläche der Stütze (4) bildet und/oder wobei die Leiterplattenfläche (9) zumindest dieselbe Größe wie die aufnehmende Fläche der Stütze (4) hat.

14. Testvorrichtung nach einem der vorherigen Ansprüche, wobei die Testvorrichtung (1) dafür ausgelegt ist, die fotovoltaische Vorrichtung (2) zwischen der Leiterplattenfläche (9) und dem flexiblen Element (13, 15) aufzunehmen, und/oder wobei die Testvorrichtung (1) derart ausgelegt ist, dass in der Messposition auf der ersten Seite der fotovoltaischen Vorrichtung (2) nur das elektrische isolierende Material des flexiblen Elementes (15) gegen die fotovoltaische Vorrichtung (2) grenzt und dass die zweite Seite der fotovoltaischen Vorrichtung (2) elektrischen Kontakt mit der Leiterplattenfläche (9) hat, wobei die erste Seite der fotovoltaischen Vorrichtung (2) - in der Messposition - elektrisch von der Testvorrichtung (1) oder von einem ihrer Teile abgekoppelt ist.

15. Verfahren zum Testen einer fotovoltaischen Vorrichtung (2), insbesondere eines Solarzellenelementes, einer Solarzelle und/oder einer Kette von Solarzellen, mit einer Testvorrichtung (1) nach einem der vorherigen Ansprüche, das die folgenden Schritte umfasst:
Herstellen einer temporären elektrischen Verbindung zwischen der elektrischen Schnittstelle (7) und der fotovoltaischen Vorrichtung (2) durch Zusammenbringen von mindestens einem der freigelegten elektrischen Kontakte (8) der elektrischen Schnittstelle (7) mit mindestens einem der elektrischen Kontakte (8) der fotovoltaischen Vorrichtung (2),
vorzugsweise kraftvolles Zusammenbringen der elektrischen Schnittstelle (7) und der fotovoltaischen Vorrichtung (2),
Ausführen einer Testmessung, wobei die Testmessung vorzugsweise durch Anlegen einer Spannung oder eines Stroms an die fotovoltaische Vorrichtung (2) und/oder durch Messen der Spannung oder des Stroms von der fotovoltaischen Vorrichtung (2) ausgeführt wird.

## Revendications

1. Dispositif d'essai (1) destiné à tester un dispositif photovoltaïque (2), en particulier un élément de cellule solaire, une cellule solaire et/ou une chaîne de cellules solaires, comportant des contacts électriques (3) sur au moins une de ses surfaces planes, le dispositif d'essai (1) comprenant :
- un support (4) comportant une surface de réception (5) pour recevoir le dispositif photovoltaïque (2),
- au moins un dispositif de mesure (6),
- au moins une interface électrique (7) comportant des contacts électriques exposés (8) destinés à venir à butée contre au moins l'un des contacts électriques (3) du dispositif photovoltaïque (2), de manière à établir une connexion électrique temporaire,
- un moyen de poussée (16) pour pousser l'interface électrique (7) et le dispositif photovoltaïque (2) l'un contre l'autre quand le dispositif photovoltaïque (2) est reçu par le support (4),
dans lequel l'interface électrique (7) est connectée au dispositif de mesure (6),
**caractérisé en ce que** l'interface électrique (7) comprend une surface de circuit imprimé (9) formée par des structures conductrices imprimées (26) sur un matériau électriquement isolant (27), et **en ce que** le dispositif d'essai (1) comprend au moins un élément flexible (13, 15) en matériau électriquement isolant, l'élément flexible (13, 15) coopérant avec le moyen de poussée (16) ou formant celui-ci pour pousser l'un contre l'autre l'interface électrique (7) et le dispositif photovoltaïque (2).

2. Dispositif d'essai selon la revendication 1, dans lequel au moins un contact électrique exposé (8), de préférence certains ou tous les contacts électriques exposés (8), est connecté au matériau électriquement isolant (27) de manière inamovible, de telle sorte que le contact électrique exposé (8) dans son ensemble est inamovible par rapport au matériau électriquement isolant (27), et/ou dans lequel au moins un des contacts électriques exposés (8) est formé par les structures conductrices imprimées (26) de la surface de circuit imprimé (9), de préférence par des contacts plaqués or.

3. Dispositif d'essai selon l'une des revendications précédentes, dans lequel au moins un des contacts électriques exposés (8) est formé par un élément électroconducteur (28) qui est connecté de manière inamovible à une structure conductrice imprimée (26) de la surface de circuit imprimé (9), de préférence au moyen de soudure (29) ou d'un adhésif électroconducteur, et/ou dans lequel la surface de contact de contacts électriques exposés (8) destinée à toucher un contact électrique (3) du dispositif photovoltaïque (2) est surélevée par rapport au matériau électriquement isolant (27), de préférence d'une distance (D) ne dépassant pas 2 mm, et de préférence ne dépassant pas 1 mm.

4. Dispositif d'essai selon l'une quelconque des revendications précédentes, dans lequel le moyen de poussée (16) est adapté pour pousser la surface de circuit imprimé (9) et le dispositif photovoltaïque (2) l'un contre l'autre quand le dispositif photovoltaïque (2) est reçu par le support (4), et/ou dans lequel le support (4) présente une forme convexe définissant une surface de réception convexe (5).

5. Dispositif d'essai selon l'une quelconque des revendications précédentes, dans lequel des contacts électriques exposés (8) sont interconnectés par un chemin conducteur (22) de la surface de circuit imprimé (9), le chemin conducteur (22) étant connecté au moins localement au matériau électriquement isolant (27), dans lequel un premier groupe (G1) de contacts électriques exposés (8) présente de préférence une surface de contact plus grande, de préférence au moins deux fois plus grande, qu'un deuxième groupe (G2) de contacts électriques exposés (8).

6. Dispositif d'essai selon l'une quelconque des revendications précédentes, dans lequel l'interface électrique (7) peut être montée dans le dispositif d'essai (1) de manière détachable, le support (4) ayant de préférence une portion inférieure (4a) et une portion supérieure (4b), la portion supérieure (4b) comprenant la surface de circuit imprimé (9) et pouvant être montée sur la portion inférieure (4a) de manière détachable, et/ou dans lequel au moins un composant électronique (12), de préférence un commutateur, un capteur, une résistance, un condensateur, une bobine et/ou un élément de chauffe, est monté sur l'interface électrique (7), de préférence sur le circuit imprimé (10), dans lequel le composant électronique (12) est monté de préférence sur la surface de l'interface électrique (7) opposée à la surface de circuit imprimé (9).

7. Dispositif d'essai selon l'une quelconque des revendications précédentes, dans lequel la surface de circuit imprimé (9) est formée par un élément en forme de plaque, de préférence par un circuit imprimé (10), l'élément en forme de plaque étant de préférence flexible, et/ou dans lequel la surface de circuit imprimé (9) est pourvue sur une portion amovible et/ou échangeable du dispositif d'essai (1), dans lequel il existe de préférence des moyens de fixation, tels que des vis, des agrafes, etc., pourvus dans le dispositif d'essai (1) pour fixer la portion amovible et/ou échangeable.

8. Dispositif d'essai selon l'une quelconque des revendications précédentes, dans lequel l'élément flexible (13, 15) est au moins partiellement transparent, dans lequel le matériau électriquement isolant de l'élément flexible (13, 15) est de préférence complètement transparent, et/ou dans lequel l'élément flexible (13, 15) est adapté pour toucher directement ou s'appuyer contre le dispositif photovoltaïque (2) dans la position de mesurage, et/ou dans lequel l'élément flexible (13, 15) s'étend de manière continue au-dessus de la surface de réception au-dessus d'au moins un bord de la surface de réception, de préférence au-dessus de deux bords opposés.

9. Dispositif d'essai selon l'une quelconque des revendications précédentes, dans lequel l'élément flexible (15) présente une extension longitudinale et dans lequel l'élément flexible (15) et/ou un élément de renfort longitudinal (30) connecté à l'élément flexible (15) est mis en tension en direction de l'extension longitudinale de l'élément flexible (15), dans lequel la tension dans l'élément flexible (15) et/ou dans l'élément de renfort (30) est de préférence supérieure à 10 N, et de préférence supérieure à 30 N, dans lequel l'élément flexible (15) présente de préférence une section droite lorsqu'il n'est pas en contact avec le dispositif photovoltaïque (2), et/ou dans lequel le dispositif d'essai (1) comprend de préférence un moyen de mise sous tension (32) qui agit sur l'élément flexible (15) en direction de l'extension longitudinale de l'élément flexible (15).

10. Dispositif d'essai selon l'une quelconque des revendications précédentes, dans lequel l'élément flexible (15) est un fil, ou dans lequel l'élément flexible (15) est un fil de nylon flexible, ou dans lequel ledit au moins un élément flexible est une feuille ou une couche flexible, ou dans lequel l'élément flexible (15) comprend un manchon (31) de matériau électriquement isolant, le manchon (31) entourant au moins partiellement au moins un toron (30), dans lequel la résistance à la traction dudit au moins un toron (30) est de préférence supérieure à la résistance à la traction du manchon (31).

11. Dispositif d'essai selon l'une quelconque des revendications 1 à 9, dans lequel l'élément flexible (13), qui est de préférence un gainage, et de préférence encore un récipient comprenant une enveloppe en plastique, est rempli d'un fluide gazeux, liquide ou de type gel, ou d'un matériau granuleux, pour équilibrer la force du moyen de poussée (16), et/ou dans lequel l'élément flexible (13) est gonflable et présente une entrée (14) pour gonfler l'élément flexible (13).

12. Dispositif d'essai selon l'une des revendications précédentes, dans lequel la surface de circuit imprimé (9) est formée sur la surface de l'élément flexible (13), et/ou dans lequel la surface de circuit imprimé (9) présente une forme convexe vers ledit au moins un élément flexible (13, 15), et/ou dans lequel l'élément flexible (13) est constitué d'un matériau transparent.

13. Dispositif d'essai selon l'une quelconque des revendications précédentes, dans lequel la surface de circuit imprimé (9) forme au moins une portion de la surface de réception du support (4), et/ou dans lequel la surface de circuit imprimé (9) présente au moins la même taille que la surface de réception du support (4).

14. Dispositif d'essai selon l'une quelconque des revendications précédentes, dans lequel le dispositif d'essai (1) est adapté pour recevoir le dispositif photovoltaïque (2) entre la surface de circuit imprimé (9) et l'élément flexible (13, 15), et/ou dans lequel le dispositif d'essai (1) est adapté de telle sorte que, dans la position de mesurage, sur le premier côté du dispositif photovoltaïque (2), seul le matériau électriquement isolant de l'élément flexible (15) vient à butée contre le dispositif photovoltaïque (2), et en ce que le deuxième côté du dispositif photovoltaïque (2) est électriquement en contact avec la surface de circuit imprimé (9), dans lequel le premier côté du dispositif photovoltaïque (2) est, dans la position de mesurage, découplé électriquement du dispositif d'essai (1) ou de l'une quelconque de ses parties.

15. Procédé d'essai d'un dispositif photovoltaïque (2), en particulier d'un élément de cellule solaire, d'une cellule solaire et/ou d'une chaîne de cellules solaires, avec un dispositif d'essai (1) selon l'une des revendications précédentes, comprenant les étapes suivantes :
établissement d'une connexion électrique temporaire entre l'interface électrique (7) et le dispositif photovoltaïque (2) en réunissant au moins un des contacts électriques exposés (8) de l'interface électrique (7) et au moins un des contacts électriques (8) du dispositif photovoltaïque (2),
poussée de préférence de l'interface électrique (7) et du dispositif photovoltaïque (2) l'un contre l'autre,
mise en oeuvre d'un mesurage d'essai, dans lequel le mesurage d'essai est de préférence mis en oeuvre en appliquant une tension ou un courant au dispositif photovoltaïque (2) et/ou en mesurant la tension ou le courant provenant du dispositif photovoltaïque (2).
